# EUROPÄISCHE PATENTSCHRIFT

(11) **EP 0 263 334 B1**
(45) Veröffentlichungstag und Bekanntmachung des Hinweises auf die Patenterteilung: **21.04.1993**
(21) Anmeldenummer: 87113537.2
(22) Anmeldetag: 16.09.1987
(51) Int. Cl.: B21B 45/02, B21B 45/06, F16C 13/00, B21D 1/02, C23G 3/02, B05C 9/00, D06B 15/02, D06B 15/04, D06C 15/02

(54) **Walzen-Anordnung zur verformungsfreien Behandlung von bewegten bandförmigen Erzeugnissen**
Roller arrangement for the non-deformable treatment of moving sheet material
Agencement de rouleaux utilisé pendant le traitement de bandes continues

(30) Priorität: 09.10.1986 DE 3634367
(43) Veröffentlichungstag der Anmeldung: 13.04.1988
(73) Patentinhaber: SMS SCHLOEMANN-SIEMAG AKTIENGESELLSCHAFT, 40237 Düsseldorf (DE)
(72) Erfinder: Bald, Wilfried, D-5912 Hilchenbach (DE); Feldmann, Hugo, Dr., D-5110 Alsdorf-Warden (DE); Pabst, Manfred, D-5000 Köln 40 (DE); Fischer, Rüdiger, Dr., D-4000 Düsseldorf 1 (DE)
(74) Vertreter: Müller, Gerd, Dipl.-Ing.

(56) Entgegenhaltungen:
- EP-A- 0 049 798
- EP-A- 0 059 417
- EP-A- 0 091 540
- EP-A- 0 228 691
- EP-A- 0 230 644
- DE-A- 1 425 902
- FR-A- 2 120 047
- GB-A- 1 027 529
- GB-A- 2 057 092
- US-A- 3 040 608
- PATENT ABSTRACTS OF JAPAN, Band 11, Nr. 301 (M-628)[2748], 30. September 1987; & JP-A-62 93 016 (NIPPON STEEL CORP.) 28-04-1987
- SOVIET INVENTIONS ILLUSTRATED, section P, Woche 8550, P51P71, 7. Januar 1986, Nr. 85-315499/50, Derwent Publications Ltd, London, GB; & SU-A-1159 668 (ZHDANOV POCHVOMASH) 07-06-1985

## Beschreibung

Die Erfindung betrifft die Verwendung einer Walzenanordnung aus drehbaren, radial anstellbaren und über die gesamte Ballenlänge leicht flaschenähnlich konturierter, axial gegenläufig verstellbarer Walzen, bspw. zum Trocknen einer oder beider Oberflächen des bandförmigen Erzeugnisses.

Unter einer "verformungsfreien Behandlung" ist die Einwirkung von zwei Walzen auf ein bewegtes bandförmiges Erzeugnis unter derart geringem Druck zu verstehen, daß das Erzeugnis im wesentlichen keine bleibende Verformung seiner Kontur erfährt. Diese Vorbedingung schließt eine Veränderung der Oberfläche des Erzeugnisses ebensowenig aus, wie eine durch Entwässerung entstehende Dickenabnahme des Erzeugnisses, wie sie bspw. bei der Papierherstellung durch das Entwässern einer Faserstoffbahn als Zwischenprodukt stattfindet. Hier ist eine Dickenabnahme eine Sekundärwirkung der durch Quetschwalzen primär angestrebten Entwässerung des Zwischenproduktes.

Aus der GB-A 1 027 529 ist eine Imprägniermaschine für nicht gewebte Geflechtbahnen aus Kunststoff bekannt. Die Imprägniermaschine besteht aus zwei Sektionen. Die erste Sektion weist ein Imprägnierbad mit einer Latex-Emulsion auf, in welche die Geflechtbahn eintaucht. Zu diesem Zweck hat die Sektion ein umlaufendes Trägerband, auf dem die Geflechtbahn aus Kunststoff aufliegt und transportiert wird. In dem Imprägnierbad wird die Geflechtbahn und das Trägerband auf dem Umfang einer Lochtrommel geführt.
Die zweite Sektion enthält eine Quetschvorrichtung, um die überschüssige Latex-Emulsion aus der Geflechtbahn zu drücken. Ein Trägerband übernimmt die Geflechtbahn aus der Imprägniersektion und führt diese über eine in einem Auffangbecken gelagerte Lochtrommel. Auf der Lochtrommel bzw. auf der Geflechtbahn läuft eine Quetschrolle, auf der eine Druckrolle abläuft, welche von mehreren kleinen Anstellrollen auf Quetschdruck gefahren wird. Hinter der Quetschvorrichtung wird die getrocknete Geflechtbahn von einem weiteren Transportband übernommen.
Die Quetschvorrichtung arbeitet mit zylindrischen Trommeln und Druckrollen, die axial nicht verschieblich sind. Ein gesteuertes Trockenquetschen der Geflechtbahn über die Bandbreite gesehen ist nicht möglich. Mit zunehmendem Walzenverschleiß und infolge ungleicher Banddicken werden sich nicht kontrollierbare Feuchtigkeitsnester im Bandgeflecht ausbreiten.

Zur schnellen Einstellung eines von der Zylinderform einer Walze abweichenden Profils des Walzenballens wurde für Quetschwalzen in der Papierindustrie die sogenannte "biegegesteuerte Walze" entwickelt, bestehend aus einer festen Achse, einem drehbaren Zylindermantel und einer Anzahl von der Achse getragener hydraulischer Druckeinrichtungen mit Druckschuhen, die über die Länge der Walze verteilt an der Innenfläche des Zylindermantels angreifen und diesem somit jede gewünschte Kontur geben können. Der konstruktive Aufwand solcher "biegegesteuerten Walzen" lohnt sich jedoch nur bei sehr großen Bandbreiten, wie sie bei der Papierherstellung oder beim Walzen von Kunststoff-Folien vorkommen (DE-C 21 65 118).

Der Erfindung liegt die Aufgabe zugrunde, eine Walzenanordnung zur verformungsfreien Behandlung von bewegten bandförmigen, insbesondere faserigen Erzeugnissen anzugeben, die es gestattet, den störenden Einflüssen wie Walzenverschleiß, Walzenbiegung und ungleichmäßiger Kontur des Erzeugnisses gleichermaßen schnell und auf konstruktiv einfache Art und Weise Rechnung zu tragen. Die Lösung dieser Aufgabe ist die Verwendung einer Walzenanordnung aus drehbaren, radial anstellbaren und über die gesamte Ballenlänge leicht flaschenähnlich konturierter, axial gegenläufig verstellbarer Walzen, wobei die Konturen von zwei beiderseits des Walzenspaltes angeordneten Walzen sich in nur einer bestimmten relativen Axiallage dieser Walzen komplementär ergänzen, zum Trocken-Quetschen eines bewegten bandförmigen Erzeugnisses unter geringem Druck, wie zum Entwässern von Faserstoff, Filz, oder textilen Gewebe- oder Geflechtbahnen.

Solche Walzenanordnungen sind in den letzten Jahren für einen völlig anderen Zweck, und zwar zur Verwendung in der Walzwerkstechnik für die Verformung von Flachmaterial in Warmband- bzw. Kaltband-Walzwerken entwickelt worden (EP-A 49 798 und EP-A 91 540). Solche Walzenanordnungen sind auch zum Entfernen von Zunder von warmgewalzten Stahlbändern bekanntgeworden (EP-A 230 644 und EP-A 228 691). Die leicht S-förmige bzw. flaschenähnliche Kontur zweier zusammenarbeitender Walzen in Verbindung mit deren gegenläufiger Axialverschiebung führt in der Walzwerkstechnik dazu, das Profil des Walzbandes zu beeinflussen, um es zu verformen.

Figur 1 der Zeichnung zeigt die Neutralstellung von zwei Walzen mit übertrieben dargestellten, leicht S-förmigem Schliff, die an sich gleich sind, jedoch zueinander um 180° verdreht eingebaut sind. Nur in dieser relativen Axiallage ergänzen sich die angeschliffenen Konturen komplementär, was zu einer über die Breite gleichmäßigen Dicke des zwischen den Walzen erkennbaren Walzgutes führt.

In Figur 2 ist die obere Walze nach rechts und die untere Walze nach links verstellt, woraus sich eine negative Bombierung des Walzenspaltes ergibt, d.h. das Walzgut ist in der Mitte dünner als an den Rändern.

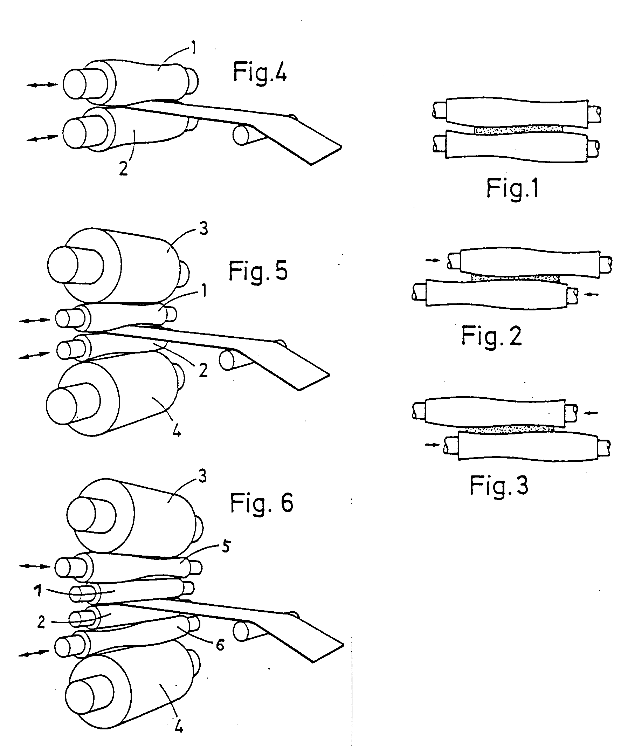

Umgekehrt zeigt Figur 3 die andere Grenzlage der Axialverschiebung der Walzen für eine positive Bombierung des Walzenspaltes, d.h. das Walzgut ist in der Mitte dicker als an den Rändern.

Zwischen den beiden Extremstellungen nach Fig. 2 und Fig. 3 kann durch die gegenläufige Axialverschiebung der Walzen das Walzprofil zwischen den Erscheinungsformen der positiven und der negativen Bombierung schnell und leicht verändert werden.

Unter "Kontur" ist die unter Umständen über die Ballenlänge hinausgehende Kurve zu verstehen, entsprechend der die Walzenoberfläche geformt ist. Dabei kann die komplementäre Ergänzung der beiden Ballenkonturen innerhalb oder außerhalb der realen Ballenlängen stattfinden. Das bedeutet, daß die Walzen nicht unbedingt eine S-förmig konturierte Gestalt aufweisen müssen. Es kann z.B. sein, daß immer nur Bandmaterial zu behandeln ist, das ein Querschnittsprofil besitzt, wie es in Fig. 2 dargestellt ist, d.h. das in der Mitte dünner ist als an den Rändern. In diesem Fall könnte das rechte Ende der oberen Walze und das linke Ende der unteren Walze jeweils um die die andere Walze überragende Länge gekürzt werden. Die Walzen hätten dann die Gestalt einer Zigarre.

Gemäß der Erfindung wird diese sogenannte "CVC" (Continuous Variable Crown)-Technik nunmehr angewendet zu dem völlig anderen Zweck, d.h. bei einer im wesentlichen verformungsfreien, mehr oberflächigen Behandlung von bandartigen, insbesondere faserigen Erzeugnissen durch Walzen die Intensität der Behandlung über die Breite des Erzeugnisses variieren zu können, um die angestrebte Wirkung der Behandlung zu optimieren.

Die Verwendung einer Walzenanordnung gemäß der Erfindung umfaßt neben dem Abquetschen von Flüssigkeit von den bandartigen Erzeugnissen mit hohem Verformungswiderstand zu deren Trocknung auch das Abquetschen oder Dosieren von Beschichtungsmaterial und reicht über das Ausquetschen von Erzeugnissen ohne nennenswerten Verformungswiderstand bis zur Oberflächenreinigung durch Bürsten, wofür in den weiterbildenden Patentansprüchen konkrete Beispiele angegeben sind, um in die Richtung weiterer Anwendungsmöglichkeiten zu weisen. Es versteht sich, daß die Walzen je nach Verwendungsbeispiel antriebslos oder positiv angetrieben sind.

Für große Breiten des zu behandelnden Erzeugnisses, bei denen Walzendurchbiegungen durch das erfindungsgemäß angewendete CVC-System nicht optimal ausgeglichen werden können, empfiehlt sich eine Mehr-Walzenanordnung mit Stützwalzen und/oder Zwischenwalzen nach dem Patentanspruch 2, wie sie in den Fig. 5 und 6 dargestellt ist und auch zu einer feinfühligen Einstellung der im Betrieb wirksamen Kontur der Behandlungswalzen verwendet werden kann. Die konstruktive Gestaltung der Axialverschiebevorrichtungen für Walzen in Walzwerken (EP-A 59 417) kann erfindungsgemäß auch in Verbindung mit Biegeeinrichtungen für die Walzen zur weiteren feinfühligen Beeinflussung des Behandlungsprofils der Behandlungswalzen im Betrieb angewendet werden. Ist ein Durchhängen dünner oder langer Behandlungswalzen unter Eigengewicht zu befürchten, empfiehlt sich im Rahmen der Erfindung für die Oberwalze eine negative und für die Unterwalze eine Positive Walzen-Gegenbiegung.

Es ist festzuhalten, daß eine gegenläufige axiale Verschiebung von Walzen nicht grundsätzlich von der neutralen Axiallage nach Fig. 1 ausgehen muß. Um einem ungleichmäßigen Walzenverschleiß zu begegnen ist es zweckmäßig, beide Behandlungswalzen zeitweise gemeinsam axial zu verschieben und von dieser Walzenlage ausgehend durch gegenläufiges Verstellen der Walzen das Behandlungsprofil zu beeinflussen.

In der Zeichnung sind einige Ausführungsbeispiele für die Verwendung von Walzenanordnungen gemäß der Erfindung dargestellt, und zwar zeigen
- Figur 1 bis 3: die bereits beschriebenen Duo-Walzenanordnungen mit übertrieben dargestelltem CVC-Schliff der Walzen in drei verschiedenen relativen Axialstellungen der beiden Walzen zueinander, wobei die Pfeile die erforderlichen Axialverschiebevorrichtungen andeuten,
- Figur 4: eine schaubildliche Darstellung der Duo-Walzenanordnung nach Fig. 1,
- Figur 5: eine Quarto-Walzenanordnung in schaubildlicher Darstellung,
- Figur 6: eine Sexto-Walzenanordnung in schaubildlicher Darstellung,

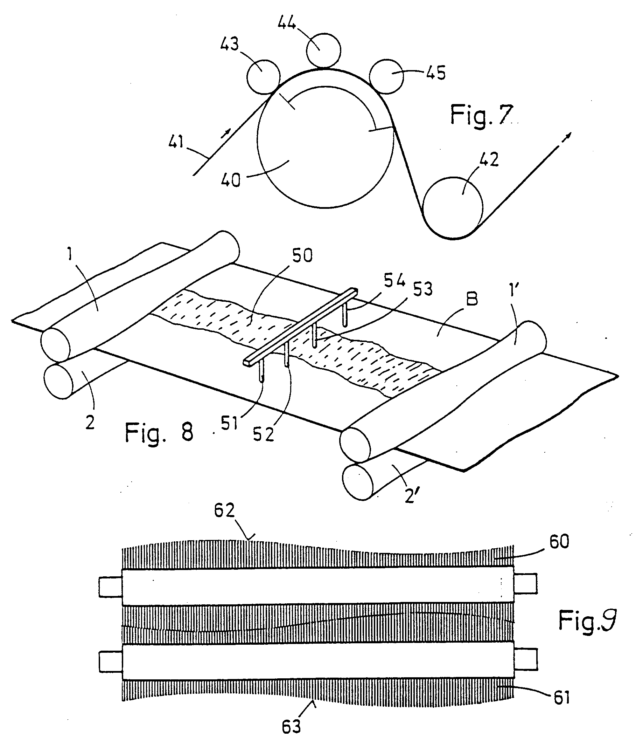

- Figur 7: eine sogenannte Naßpresse für die Papierherstellung in schematischer Darstellung,
- Figur 8: eine schaubildliche Darstellung von zwei aufeinanderfolgenden Duo-Walzenanordnungen nach Fig. 4,
- Figur 9: eine Walzenanordnung mit Bürstenwalzen,

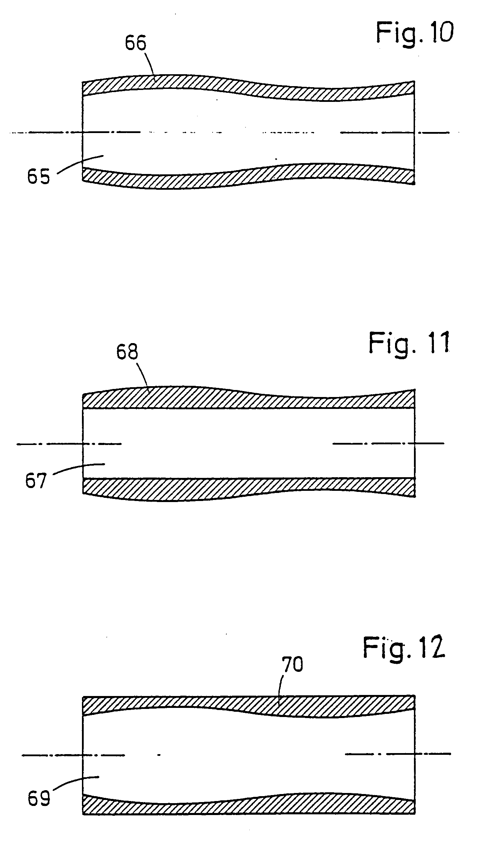

- Figuren 10-12: Ausführungsbeispiele für konturierte Walzen mit einem Mantel aus elastischem Material, zum Entfeuchten von textilen Flächengebilden.

Zur Erläuterung der verschiedenen Walzenanordnungen nach den Fig. 4 bis 6 ist auszuführen, daß ein Duo-Walzensatz nach Fig. 4 mit erfindungsgemäß konturierten bzw. mit CVC-Schliff versehenen Behandlungswalzen 1 und 2 zum Bearbeiten eines bandförmigen Erzeugnisses B in der Praxis die häufigste Verwendung finden dürfte, nämlich zum Abquetschen von an dem Erzeugnis B anhaftender Flüssigkeit oder zum Abquetschen von Flüssigkeit aus Faserstoff-, Filz oder textilen Gewebe oder Geflechtbahnen. Die Walzen 1 und 2 sind im Sinne von Fig. 1 bis 3 axial verschiebbar, um das Behandlungsprofil der Walzen optimal an die vom flächigen Erzeugnis vorgegebenen Verhältnisse anzupassen. In Fig. 5 sind die beiden konturierten und axial verschiebbaren Behandlungswalzen 1 und 2 durch dicke zylindrische Stützwalzen 3 und 4 abgestützt. In Fig. 6 sind die Behandlungswalzen 1 und 2 sowie die äußeren Stützwalzen 3 und 4 zylindrisch, wohingegen die Zwischenwalzen 5 und 6 mit CVC-Schliff versehen und gegenläufig axial verschiebbar sind. Die Walzenanordnungen nach Fig. 5 und 6 sind für große Walzenlängen zu empfehlen.

Die Naßpresse nach Fig. 7 ist für die Papierindustrie bestimmt und besteht aus einer axial unverschieblichen Behandlungswalze 40, die von einer vorentwässerten Faserstoffbahn 41 teilweise umschlungen ist und über eine Umlenkrolle 42 gegebenenfalls zur nächsten Naßpresse weiterläuft. Innerhalb des Umschlingungswinkels sind um die Behandlungswalze 40 drei axial verstellbare Behandlungswalzen 43, 44, 45 kleineren Durchmessers angeordnet, die radial gegen den Umfang der Behandlungswalze 40 angepreßt sind. Die Behandlungswalze 40 hat einen CVC-Schliff entsprechend der Behandlungswalze 2 in Fig. 4, wogegen die angedrückten kleineren Walzen 43, 44 und 45 mit dem CVC-Schliff der Behandlungswalze 1 in Fig. 4 versehen sind. Auf diese Weise werden auf engstem Raum drei Preßspalte zum weiteren Entwässern der Faserstoffbahn 41 geschaffen, die über das CVC-System in ihrer relativen Axiallage unterschiedlich eingestellt werden können, bspw. um die Feuchtigkeit aus der Faserstoffbahn 41 von der Mitte aus zu den Bandrändern hin auszupressen. Die Entwässerung kann - wie in der Papierindustrie bekannt - dadurch gefördert werden, daß die Behandlungswalze 40 als Saugwalze ausgebildet ist, d.h. aus einem gelochten, drehbaren Siebmantel besteht, in dessen Innerem ein unter Unterdruck stehender Saugkasten im Bereich der Entwässerungszone stationär angeordnet ist.

Die schaubildliche Darstellung nach Fig. 8 zeigt die Aufeinanderfolge zweier Duo-Walzen-Anordnungen nach Fig. 4 zum Abquetschen von auf dem Band B anhaftender Flüssigkeit. Das in der Bewegungsrichtung des Bandes zuerst durchlaufende Walzenpaar 1, 2 steht in der axialen Neutralstellung nach Fig. 1. Aus visueller Beobachtung kann entnommen werden, daß die Quetschwirkung der Walzen 1, 2 in der Bandmitte nicht optimal ist, da hier noch eine mittlere Feuchtigkeitszone 50 erkennbar ist. Die Axialverschiebung beider Quetschwalzenpaare ist unabhängig voneinander zu betätigen, so daß das zweite Quetschwalzenpaar 1', 2' in einer Axialstellung der Walzen nach Fig. 2 eine erhöhte Quetschwirkung der Walzen in der Mitte aufweist. Dadurch wird eine Optimierung des Trocknungseffektes erreicht.

Die korrigierende Axial-Einstellung des zweiten Quetschwalzenpaares 1', 2' kann auch automatisiert werden, wenn zwischen den aufeinanderfolgenden Walzen-Anordnungen quer zur Bewegungsrichtung der Bahn B mehrere Sensoren 51 bis 54, im Ausführungsbeispiel Flüssigkeitssensoren, zur örtlichen Feststellung des Behandlungszustandes des Erzeugnisses vorgesehen werden. In Fig. 8 spricht der Flüssigkeitssensor 53 an und liefert ein Signal, in dessen Abhängigkeit die nicht gezeigte Axial-Verschiebevorrichtung für die nachgeordnete Walzen-Anordnung betätigt wird.

Die Ausbildung einer Walzen-Anordnung als Bürstwalzen nach Fig. 9 ist nur in Duo-Anordnung sinnvoll. Charakteristisch für das CVC-System ist auch hier, daß die Außenkontur 62 bzw. 63 der Borsten 60 bzw. 61, leicht S-förmig bzw. flaschenähnlich ausgebildet ist.

In Richtung einer positiven Bombierung nach Fig. 2 kann die Bürstwirkung in der Mitte verstärkt werden, wogegen bei einer negativ eingestellten wirksamen Bombierung der Bürstwalzen die stärkere Bürstwirkung an den Rändern eines Bandes auftritt. Auch bei als Bürstwalzen ausgebildeten Walzen-Anordnungen empfiehlt sich mindestens die Doppel-Anordnung von Bürstwalzenpaaren entsprechend Fig. 8.

Für das Entfeuchten von textilen Flächengebilden in Verbindung mit einem Veredelungsvorgang kann es zweckmäßig sein, die Walzen mit einem Mantel aus elastischem Material, z.B. Gummi, zu beschichten. Fig. 10 zeigt einen Walzenkern 65 mit CVC-Schliff, auf den ein Gummimantel 66 mit gleichbleibender Wandstärke aufvulkanisiert ist, so daß die mit dem zu behandelnden Gut in Berührung gelangende Oberfläche ebenfalls CVC-Kontur hat. Die Beschichtung von CVC-Walzen mit elastischem Material erlaubt eine schonende und zugleich griffige Druckausübung auf das zu entfeuchtende textile Flächengebilde, insbesondere dünnes Gewebe.

Bekanntlich ist eine Verformung von Gummi unter Druck stets von der Verdrängung von Material begleitet, die im vorliegenden Fall von zusammenarbeitenden CVC-Walzen mit Gummimantel im Walzspalt sowohl in Umfangsrichtung als auch in Achsrichtung der Walzen geht. Jede im Walzenspalt vorübergehend auftretende Materialverdrängung führt jedoch dazu, daß das durchlaufende textile Flächengebilde unterschiedlich gezerrt wird. Es kann sich daher empfehlen, gummibeschichtete CVC-Walzen so auszubilden, daß der CVC-Effekt auch bei über die Länge unterschiedlicher Dicke des Gummimantels vorliegt. So zeigt bspw. Fig. 11 eine Walze mit einem zylindrischen, harten Kern 67 aus Metall mit einem elastischen Mantel 68, dessen Außenfläche konturiert ist und somit über die Länge unterschiedliche Wandstärken hat. Im Ausführungsbeispiel nach Fig. 12 ist der harte Kern 69 als eigentliche Walze konturiert, wogegen der elastische Gummimantel 70 außen zylindrisch ist. Der Erhalt des CVC-Effektes trotz zylindrischem Außenmantel eines Walzenpaares nach Fig. 12 ist daraus zu erklären, daß der elastische Mantel 70 im dickeren Bereich des konturierten Kerns 69 wegen der geringeren Wandstärke härter ist als in dem taillierten Bereich des Kerns 69.

Nicht dargestellt ist eine Walze, deren Mantel aus elastischem Material mehrschichtig mit derart schichtweise unterschiedlichen Elastizitätsmodulen und gegebenenfalls Abmessungen ausgebildet ist, daß die äußere, mit dem zu behandelnden Gut in Berührung gelangende Schicht im Walzenspalt über dessen in Anspruch genommene Länge ein gleiches Federverhalten aufweist. Mit einem gleichen Federverhalten des elastischen Materials unabhängig von der relativen Axiallage der CVC-Walzen werden unerwünschte Auswirkungen örtlich erhöhter Materialverdrängungen der elastischen Außenschicht auf das zu behandelnde Gut unterdrückt.

## Patentansprüche

1. Verwendung einer Walzenanordnung aus drehbaren, radial anstellbaren und über die gesamte Ballenlänge leicht flaschenähnlich konturierter, axial gegenläufig verstellbarer Walzen (1, 2, 5, 6, 40, 43, 44, 45), wobei die Konturen von zwei beiderseits des Walzenspaltes angeordneten Walzen sich in nur einer bestimmten relativen Axiallage dieser Walzen komplementär ergänzen, zum Trocken-Quetschen eines bewegten bandförmigen Erzeugnisses unter geringem Druck,
wie zum Entwässern von Faserstoff-, Filz oder textilen Gewebe- oder Geflechtbahnen.

2. Verwendung der Walzenanordnung nach Anspruch 1,
wobei die auf das Erzeugnis unmittelbar einwirkenden Behandlungswalzen (1, 2) durch äußere Stützwalzen (3, 4) oder zusätzliche Zwischenwalzen (5, 6) abgestützt sind, und daß mindestens die konturierten Walzen eines gleichnamigen Walzenpaares (Behandlungswalzen oder Zwischenwalzen oder Stützwalzen) gegenläufig verstellbar sind.

3. Verwendung der Walzenanordnung nach Anspruch 1,
mit einer axial unverschieblichen Behandlungswalze (40) größeren Durchmessers, um die zwei oder mehr axial verstellbare Behandlungswalzen (43, 44, 45) kleineren Durchmessers umfangsverteilt angeordnet sind (Fig. 7).

4. Verwendung der Walzenanordnung nach Anspruch 1 und Anspruch 3,
wobei die Behandlungswalze (40) größeren Durchmessers als Saugwalze ausgebildet ist.

5. Verwendung der Walzenanordnung nach Anspruch 1 bis 4,
wobei zwischen aufeinanderfolgenden Walzen-Anordnungen quer zur Bewegungsrichtung des bandförmigen Erzeugnisses (B) mehrere Sensoren (51, 52, 53, 54) zur örtlichen Feststellung des Behandlungszustandes des Erzeugnisses vorgesehen sind, und daß die axialen Verschiebevorrichtungen der konturierten Walzen der jeweils folgenden Walzen-Anordnung in Abhängigkeit von den Signalen der vorgeordneten Sensoren betätigbar sind.

6. Verwendung der Walzenanordnung nach Anspruch 1 bis Anspruch 5,
wobei die Walzen (1, 2) mit einem Mantel (66) aus elastischem Material, z.B. Gummi, beschichtet sind (Fig. 10).

7. Verwendung der Walzenanordnung nach Anspruch 6,
wobei die Walzen (1, 2) einen zylindrischen, harten Kern (67) aus Metall aufweisen, und daß der elastische Mantel (68) außen leicht flaschenähnlich konturiert ist (Fig. 11).

8. Verwendung der Walzenanordnung nach Anspruch 6,
wobei die Walzen (1, 2) eine leicht flaschenähnlich konturierten, harten Kern (69) aus Metall aufweisen, und daß der elastische Mantel (70) außen zylindrisch ist (Fig. 12).

9. Verwendung der Walzenanordnung nach Anspruch 6,
wobei die Walzen (1, 2) einen leicht flaschenähnlich konturierten harten Kern aus Metall aufweisen, und daß der elastische Mantel über die ganze Ballenlänge gleiche Schichtdicke aufweist.

10. Verwendung der Walzenanordnung nach Anspruch 6 bis 9,
wobei der Mantel aus elastischem Material mehrschichtig mit derart schichtweise unterschiedlichen Elastizitätsmodulen und gegebenenfalls mit solchen Abmessungen ausgebildet ist, daß die äußere, mit dem zu behandelnden Erzeugnis in Berührung gelangende Schicht im Walzspalt über dessen in Anspruch genommene Länge ein gleiches Federverhalten aufweist.

## Claims

1. Use of a roll arrangement of rotatable, radially adjustable rolls (1, 2, 5, 6, 40, 43, 44, 45), which are axially displaceable in opposite sense and which are contoured over the entire surface length to be slightly bottle-like, wherein the contours of two rolls arranged at both sides of a roll gap conjunctively complement one another in only one determined relative position of these rolls, for squeeze-drying of a transported striplike product under low pressure, such as for the drying of fibrous, felt or textile fabric or textured webs.

2. Use of the roll arrangement according to claim 1, wherein the treatment rolls (1, 2) acting directly on the product are supported by outer support rolls (3, 4) on additional intermediate rolls (5, 6) and that at least the contoured rolls of a like roll pair (treatment rolls or intermediate rolls or support rolls) are displaceable in opposite sense.

3. Use of the roll arrangement according to claim 1, with an axially non-displaceable treatment roll (40) of a larger diameter, around which two or more axially displaceable and circumferentially distributed treatment rolls (43, 44, 45) of smaller diameter are arranged (Fig. 7).

4. Use of the roll arrangement according to claim 1 and claim 3, wherein the treatment roll (4) of larger diameter is constructed as a suction roll.

5. Use of the roll arrangement according to claims 1 to 4, wherein several sensors (51, 52, 53, 54) for local determination of the treatment state of the product are provided between successive roll arrangements and transversely to the transport direction of the striplike product (B), and that the axial displacing devices of the contoured rolls of each succeeding roll arrangement are actuable in dependence on the signals of the sensors arranged in front.

6. Use of the roll arrangement according to claim 1 to claim 5, wherein the rolls (1, 2) are coated with a shell (66) of resilient material, for example rubber (Fig. 10).

7. Use of the roll arrangement according to claim 6, wherein the rolls (1, 2) have a cylindrical hard core (67) of metal and that the resilient shell (68) is contoured to be slightly bottle-like at the outside (Fig. 11).

8. Use of the roll arrangement according to claim 6, wherein the rolls (1, 2) have a hard core (69) of metal contoured to be slightly bottle-like and that the resilient shell (70) is cylindrical at the outside (Fig. 12).

9. Use of the roll arrangement according to claim 6, wherein the rolls (1, 2) have a hard core of metal contoured to be slightly bottle-like and that the resilient shell has the same layer thickness over the entire surface length.

10. Use of the roll arrangement according to claim 6 to 9, wherein the shell is constructed from resilient material multilayered with such different moduli of elasticity layer by layer and in a given case with such dimensions that the outer layer, which comes into contact with the product to be treated, in the roll gap has a uniform spring behaviour over the engaged length thereof.

## Revendications

1. Utilisation d'un agencement de rouleaux, constitué par des rouleaux (1,2,5,6,40,43,44,45) rotatifs, positionnables radialement, de forme légèrement façonnée à la manière d'une bouteille sur toute la longureur de table, déplaçables axialement en sens opposés, les contours de deux rouleaux agencés de part et d'autre de la fente entre rouleaux ne se complétant de façon complémentaire qu'en une position axiale relative déterminée de cesrouleaux, pour le pressage à sec sous pression peu élevée d'un produit en forme de bande en mouvement, comme l'égouttage de bandes de matière textile, de feutre ou de bandes textiles tissés ou tressés.

2. Utilisation de l'agencement de rouleaux selon la revendication 1, dans laquelle les rouleaux de traitement (1,2) agissant directement sur le produit prennent appui sur des rouleaux d'appui externes (3,4) ou sur des rouleaux intermédiaires supplémentaires (5,6), au moins les rouleaux façonnés d'une même paire de rouleaux (rouleaux de traitement ou rouleaux intermédiaires) étant déplaçables en sens opposés.

3. Utilisation de l'agencement de rouleaux selon la revendication 1 comportant un rouleau de traitement (40) non déplaçable axialement, d'un diamètre plus important, autour duquel sont agencés deux ou plusieurs rouleaux de traitement (43,44,45) axialement déplaçables de plus faible diamètre, de manière répartie sur le pourtour (figure 7).

4. Utilisation de l'agencement de rouleaux selon les revendications 1 et 3, dans laquelle le rouleau de traitement (40) de plus grand diamètre consiste en un rouleau aspirant.

5. Utilisation de l'agencement de rouleaux selon les revendications 1 à 4, dans laquelle plusieurs sondes (51,52,53,54) sont agencées entre des agencements de rouleaux successifs, perpendiculairement à la direction de déplacement du produit en forme de bande (B), pour la détermination locale de l'état de traitement du produit, et dans laquelle les dispositifs de déplacement axial des rouleaux faconnés de l'agencement de rouleaux suivant sont actionnables en fonction des signaux des sondes montées en amont.

6. Utilisation de l'agencementde rouleaux selon les revendications 1 à 5, dans laquelle les rouleaux (1,2) sont enrobés d'une enveloppe (66) en un matériau élastique, par exemple en caoutchouc (figure 10).

7. Utilisation de l'agencement de rouleaux selon la revendication 6 dans laquelle les rouleaux (1,2) comportent un noyau cylindrique métallique dur (67) et l'enveloppe élastique (68) est extérieurement légèrement façonnée à la manière d'une bouteille (figure 11).

8. Utilisation de l'agencement de rouleaux selon la revendication 6 dans laquelle les rouleaux (1,2) comportent un noyau métallique dur (69) légèremnt façonné à la manière d'une bouteille, et dans laquelle l'enveloppe élastique (70) est cylindrique à l'extérieur (figure 12)

9. Utilisation de l'agencement de rouleaux selon la revendication 6 dans laquelle les rouleaux (1,2) comportent un noyau métallique dur légèrementfaçonné à la manière d'une bouteille, et dans laquelle l'enveloppe élastique présente la même épaisseur sur toute la longueur de table.

10. Utilisation de l'agencement de rouleaux selon les revendications 6 à 9 dans laquelle l'enveloppe en matériau élastique est stratifiée et présente des modules d'élasticité différents par couche et éventuellement des dimensions, tel que la couche externe qui entre en contact avec le produit à traiter dans la fente entre rouleaux présente un comportement élastique identique sur la longueur empruntée.
